# EUROPEAN PATENT APPLICATION

(11) **EP 2 450 957 A2**
(43) Date of publication of application: **09.05.2012**
(21) Application number: 11187679.3
(22) Date of filing: 03.11.2011
(51) Int. Cl.: H01L 31/0224, H01L 31/0304, H01L 31/0735, H01L 31/18, C23C 16/06, C23C 16/30

(54) **Metallic contacts for photovoltaic devices and low temperature fabrication processes thereof**

(30) Priority: 03.11.2010 US 939050
(71) Applicant: Alta Devices, Inc., Santa Clara, CA 95054 (US)
(72) Inventor: Kayes, Brendan M., San Francisco, CA California 94110 (US); Kizilyalli, Isik C., San Francisco, CA California 94117 (US); Nie, Hui, Cupertino, CA California (US); Archer, Melissa J., San Jose, CA California 95054 (US)
(74) Representative: Maggs, Michael Norman

(57) **Abstract**

Embodiments of the invention generally relate to photovoltaic devices and more specifically, to the metallic contacts disposed on photovoltaic devices, such as photovoltaic cells, and to the fabrication processes for forming such metallic contacts. The metallic contacts contain a palladium germanium alloy formed at low temperatures during an anneal process. In some embodiments, the photovoltaic cell may be heated to a temperature within a range from about 20°Cto about 275°Cduring the anneal process, for example, at about 150°Cfor about 30 minutes. In other embodiments, the photovoltaic cell may be heated to a temperature within a range from about 150°Cto about 275°Cfor a time period of at least about 0.5 minutes during the anneal process.

## Description

### BACKGROUND OF THE INVENTION

### Field of the Invention

Embodiments of the invention generally relate to photovoltaic devices, such as solar cells, and methods for fabricating such photovoltaic devices.

### Description of the Related Art

As fossil fuels are being depleted at ever-increasing rates, the need for alternative energy sources is becoming more and more apparent. Energy derived from wind, from the sun, and from flowing water offer renewable, environment-friendly alternatives to fossil fuels, such as coal, oil, and natural gas. Being readily available almost anywhere on Earth, solar energy may someday be a viable alternative.

To harness energy from the sun, the junction of a solar cell absorbs photons to produce electron-hole pairs, which are separated by the internal electric field of the junction to generate a voltage, thereby converting light energy to electric energy. The generated voltage can be increased by connecting solar cells in series, and the current may be increased by connecting solar cells in parallel. Solar cells may be grouped together on solar panels. An inverter may be coupled to several solar panels to convert DC power to AC power.

Nevertheless, the currently high cost of producing solar cells relative to the low efficiency levels of contemporary devices is preventing solar cells from becoming a mainstream energy source and limiting the applications to which solar cells may be suited. During conventional fabrication processes for photovoltaic devices, metallic contacts are often deposited with a vapor deposition process, and usually heated to temperatures of over 300°Cduring thermal anneal processes. These high temperature processes are generally expensive due to the excessive consumption of time and energy. Also, the high temperature processes often damage sensitive materials contained within the photovoltaic device.

Accordingly, there is a need for photovoltaic devices with increased efficiency and methods for fabricating such photovoltaic devices at reduced costs when compared to conventional solar cells.

### SUMMARY OF THE INVENTION

Embodiments of the invention generally relate to optoelectronic semiconductor devices such as photovoltaic devices and more specifically, to the metallic contacts disposed on photovoltaic devices, such as photovoltaic cells, and to the fabrication processes for forming such metallic contacts.

In one embodiment, a metallic contact disposed on a photovoltaic device, such as a photovoltaic cell is provided and includes a palladium germanium alloy layer disposed on an absorber layer of the photovoltaic cell, and a metallic capping layer disposed on the palladium germanium alloy layer. For example, the capping layer can include an adhesion layer disposed on the palladium germanium alloy layer, and a conductive layer disposed on the adhesion layer. In some examples, the palladium germanium alloy layer may have a thickness within a range from about 100 Å to about 1,000 Å, such as from about 300 Å to about 600 Å. The adhesion layer may have a thickness within a range of at least about 20 Å. The conductive layer may have a thickness of at least about 1,000 Å.

In another embodiment, a method for forming a metallic contact on a photovoltaic device is provided and includes depositing a palladium layer on an absorber layer of a photovoltaic cell, depositing a germanium layer on the palladium layer, depositing a metallic capping layer on the germanium layer, and heating the photovoltaic cell to a temperature within a range from about 20°Cto about 275°Cduring an anneal process. For example, depositing the capping layer can include depositing an adhesion layer on the germanium layer and depositing a conductive layer on the adhesion layer The palladium layer and the germanium layer form a palladium germanium alloy disposed between the absorber layer and the adhesion layer. In some examples, the photovoltaic cell may be heated to a temperature within a range from about 20°Cto about 175°Cfor a time period within a range from about 5 minutes to about 60 minutes, such as from about 100°Cto about 150°C;or heated to a temperature within a range from about 150°Cto about 275°Cand for a time period for at least about 0.5 minutes during the anneal process.

The palladium layer may have a thickness within a range from about 50 Å to about 300 Å and may be deposited at a temperature within a range from about 20°Cto about 200°Cduring a deposition process. The germanium layer may have a thickness within a range from about 100 Å to about 1000 Å and may be deposited at a temperature within a range from about 20°Cto about 200°Cduring a deposition process. In some examples, the adhesion layer contains titanium or a titanium alloy and has a thickness of at least about 20 Å. In other examples, the conductive layer contains gold or a gold alloy and has a thickness of at least about 1,000 Å. In other aspects, the absorber layer of the photovoltaic cell often contains an n-type gallium arsenide material while the metallic contact may be disposed on the back side of the photovoltaic cell.

### BRIEF DESCRIPTION OF THE DRAWINGS

So that the manner in which the above recited features of the invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figures 1A-1B depict a cross-sectional view of a photovoltaic unit in accordance with one embodiment described herein;

Figure 2 depicts a cross-sectional view of a two-sided photovoltaic cell in accordance with some embodiments described herein;

Figure 3 depicts a cross-sectional view of a single-sided photovoltaic cell in accordance with other embodiments described herein; and

Figures 4A and 4B depict a cross-sectional view of metallic contact in accordance with some embodiments described herein.

### DETAILED DESCRIPTION

Embodiments of the invention generally relate to photovoltaic devices and processes, and more specifically to photovoltaic cells, metallic contacts formed on the photovoltaic cells, and the fabrication processes for forming such photovoltaic cells and metallic contacts. Some of the fabrication processes include epitaxially growing thin film of gallium arsenide materials which are further processed by an epitaxial lift off (ELO) process.

Embodiments of metallic contacts described herein contain a palladium germanium alloy formed at low temperatures during an anneal process. In some embodiments, the photovoltaic cell may be heated to a temperature within a range from about 20°Cto about 275°C. For example, the cell may be heated to a temperature within a range from about 20°Cto about 175°C and/or heated for a time period within a range from about 5 minutes to about 60 minutes during the anneal process; for example, at about 150°C for about 30 minutes. In other embodiments, the photovoltaic cell may be heated to a temperature within a range from about 150°C to about 275°C for a time period of at least about 0.5 minutes during the anneal process; for example, at about 250°Cfor about 1 minute.

Some embodiments of suitable photovoltaic cells are described in embodiments herein for use with the metallic contacts. The photovoltaic cells may include a gallium arsenide based cell containing an n-type film stack disposed over a p-type film stack, such that the n-type film stack is facing the front side while the p-type film stack is on the back side of the cell. In one embodiment, the photovoltaic cell is a two-sided photovoltaic cell and has an n-metal contact disposed on the front side while a p-metal contact is disposed on the back side of the cell. In another embodiment, the photovoltaic cell is a single-sided photovoltaic cell and has the n-metal and the p-metal contacts disposed on the back side of the cell.

Some embodiments of the invention provide processes for epitaxially growing Group III-V materials at high growth rates of greater than 5 µm/hr, such as about 10 µm/hr or greater, about 20 µm/hr or greater, about 30 µm/hr or greater, such as about 60 µm/hr or greater including about 100 µm/hr or greater or about 120 µm/hr or greater. The Group III-V materials are thin films of epitaxially grown layers which contain gallium arsenide, gallium aluminum arsenide, gallium aluminum indium phosphide, gallium aluminum phosphide, or combinations thereof. In some embodiments, the metallic contacts may contain a palladium germanium alloy formed at low temperatures, such as less than 300°C,and in some examples, at temperatures less than 250°Cor less than 200°C,for example, from about 20°C(or at about room temperature) to about 150°C. Such innovations may allow for greater efficiency and flexibility in photovoltaic devices when compared to conventional solar cells.

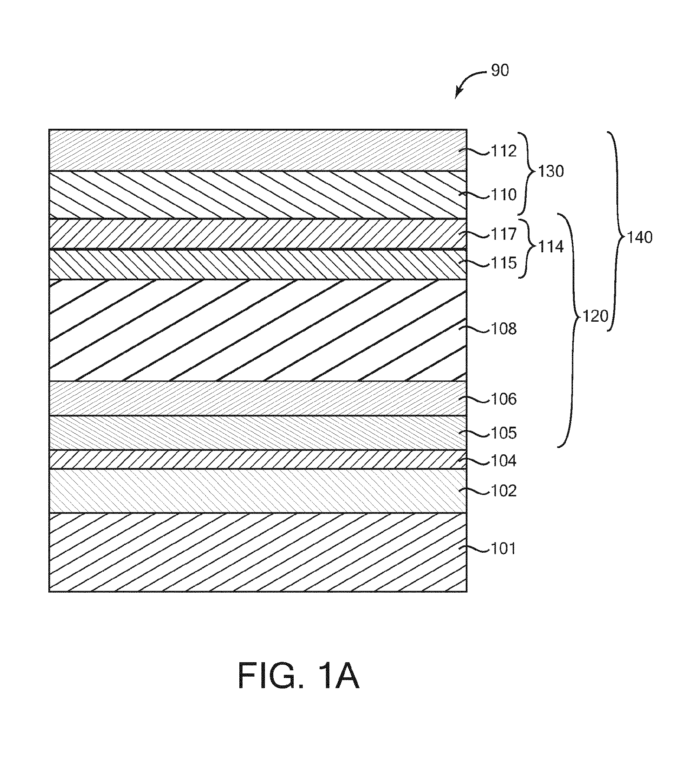

Figure 1A illustrates a cross-sectional view of a photovoltaic unit 90 containing a gallium arsenide based cell 140 coupled with a growth wafer 101 by a sacrificial layer 104 disposed therebetween. Multiple layers of epitaxial materials containing varying compositions are deposited within the photovoltaic unit 90 including the buffer layer 102, the sacrificial layer 104, as well as many of the layers contained within the gallium arsenide based cell 140. The various layers of epitaxial materials may be grown or otherwise formed by deposition process such as a chemical vapor deposition (CVD) process, a metal organic CVD (MOCVD) process, or a molecular beam epitaxy (MBE) process.

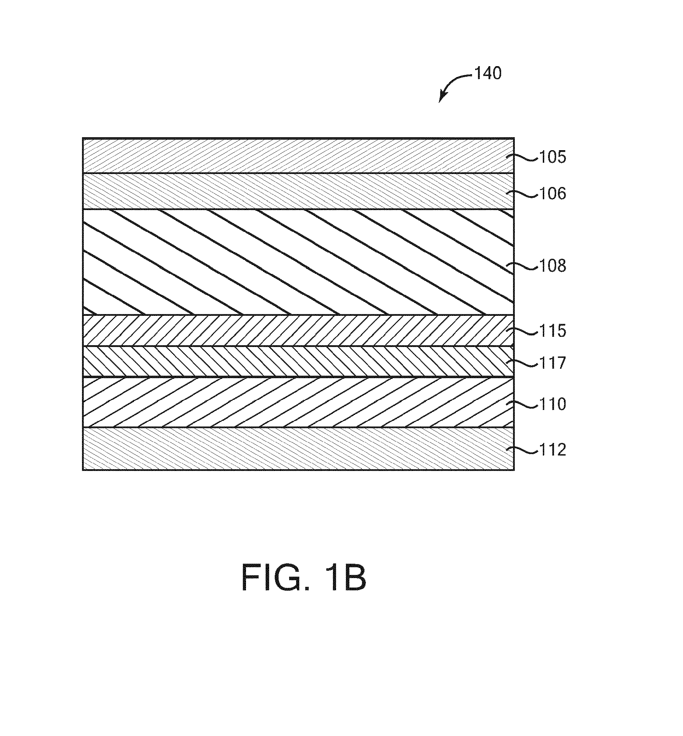

In another embodiment described herein, the photovoltaic unit 90 may be exposed to a wet etch solution in order to etch the sacrificial layer 104 and to separate the gallium arsenide based cell 140 from the growth wafer 101 during an epitaxial lift off (ELO) process. The wet etch solution generally contains hydrofluoric acid, and may also contain various additives, buffers, and/or surfactants. The wet etch solution selectively etches the sacrificial layer 104 while preserving the gallium arsenide based cell 140 and the growth wafer 101. Once separated, the gallium arsenide based cell 140, as depicted in Figure 1B, may be further processed to form a variety of photovoltaic devices, including photovoltaic cells and modules, as described by several embodiments herein.

The Group III-V materials are thin films of epitaxially grown layers which may contain gallium arsenide, gallium aluminum arsenide, among others. Some layers, such as the window layer may contain additional materials including gallium aluminum indium phosphide, gallium aluminum phosphide, or combinations thereof. The epitaxially grown layers may be formed by growing Group III-V materials during a high growth rate vapor deposition process. The high growth rate deposition process allows for growth rates of greater than 5 µm/hr, such as about 10 µm/hr or greater, about 20 µm/hr or greater, about 30 µm/hr or greater, such as about 60 µm/hr or greater including about 100 µm/hr or greater or about 120 µm/hr or greater as compared to the conventional observed deposition rates of less than 5 µm/hr.

The process includes heating a wafer to a deposition temperature of about 550°Cor greater, within a processing system, exposing the wafer to a deposition gas containing a chemical precursor, such as gallium precursor gas and arsine for a gallium arsenide deposition process, and depositing a layer containing gallium arsenide on the wafer. The high growth rate deposition process may be utilized to deposit a variety of materials, including gallium arsenide, aluminum gallium arsenide, aluminum gallium phosphide, aluminum gallium indium phosphide, aluminum indium phosphide, alloys thereof, dopant variants thereof, or combinations thereof. In some embodiments of the deposition process, the deposition temperature may be within a range from about 550°C to about 900°C. In other examples, the deposition temperature may be within a range from about 600°Cto about 800°C. In other examples, the deposition temperature may be within a range from about 650°Cto about 750°C. In other examples, the deposition temperature may be within a range from about 650°Cto about 720°C.

In one embodiment, a deposition gas may be formed by combining or mixing two, three, or more chemical precursors within a gas manifold prior to entering or passing through the showerhead. In another embodiment, the deposition gas may be formed by combining or mixing two, three, or more chemical precursors within a reaction zone after passing through the showerhead. The deposition gas may also contain one, two or more carrier gases, which may also be combined or mixed with the precursor gases prior to or subsequent to passing through the showerhead.

The deposition gas may contain one or multiple chemical precursors of gallium, aluminum, indium, arsenic, phosphorus, or others. The deposition gas may contain a gallium precursor gas which is an alkyl gallium compound, such as trimethylgallium or triethylgallium. The deposition gas may further contain an aluminum precursor gas which is an alkyl aluminum compound, such as trimethylaluminum or triethylaluminum. The deposition gas may further contain an indium precursor gas which is an alkyl indium compound, such as trimethylindium.

In some embodiments, the deposition gas further contains a carrier gas. The carrier gas may contain hydrogen (H₂), nitrogen (N₂), a mixture of hydrogen and nitrogen, argon, helium, or combinations thereof. In many examples, the carrier gas contains hydrogen, nitrogen, or a mixture of hydrogen and nitrogen. Each of the deposition gases may be provided to the processing chamber at a flow rate from about 5 sccm (standard cubic centimeters per minute) to about 300 sccm. The carrier gases may be provided to the processing chamber at a flow rate from about 500 sccm to about 3,000 sccm.

In other embodiments, the deposition gas contains the arsine and the gallium precursor gas at an arsine/gallium precursor ratio of about 3 or greater, or may be about 4 or greater, or may be about 5 or greater, or may be about 6 or greater, or may be about 7 or greater. In some examples, the arsine/gallium precursor ratio may be within a range from about 5 to about 10. In other embodiments, the Group III-V materials may be formed or grown from a deposition gas containing a ratio of Group V precursor to Group **III** precursor of about 30:1, or 40:1, or 50:1, or 60:1, or greater. In some examples, the deposition gas has a phosphine/Group III precursor of about 50:1.

The processing system may have an internal pressure within a range from about 20 Torr to about 1,000 Torr. In some embodiments, the internal pressure may be ambient or greater than ambient, such as within a range from about 760 Torr to about 1,000 Torr. In some examples, the internal pressure may be within a range from about 800 Torr to about 1,000 Torr. In other examples, the internal pressure is within a range from about 780 Torr to about 900 Torr, such as from about 800 Torr to about 850 Torr. In other embodiments, the internal pressure may be ambient or less than ambient, such as within a range from about 20 Torr to about 760 Torr, preferably, from about 50 Torr to about 450 Torr, and more preferably, from about 100 Torr to about 250 Torr.

The deposition processes for depositing or forming Group III-V materials, as described herein, may be conducted in a single wafer deposition chamber, a multi-wafer deposition chamber, a stationary deposition chamber, or a continuous feed deposition chamber. One continuous feed deposition chamber that may be utilized for growing, depositing, or otherwise forming Group III-V materials is described in the commonly assigned U.S. Ser. Nos. 12/475,131 and 12/475,169, both filed on May 29, 2009, which are herein incorporated by reference.

In one embodiment, one or more buffer layers 102 may be formed on the growth wafer 101 in order to start forming the photovoltaic unit 90. The growth wafer 101 may contain an n-type or semi-insulating material, and may contain the same or similar material as the one or more subsequently deposited buffer layers. For example, the growth wafer 101 may contain gallium arsenide, or n-doped gallium arsenide, when creating a gallium arsenide, or n-doped gallium arsenide, buffer layer. The p-dopants may be selected from carbon, magnesium, zinc, or combinations thereof while the n-dopants may be selected from silicon, selenium, tellurium, or combinations thereof. In some embodiments, p-type dopant precursors may include carbon tetrabromide (CBr₄) for a carbon dopant, bis(cyclopentadienyl)magnesium (Cp₂Mg) for a magnesium dopant, and dialkyl zinc compounds including dimethylzinc or diethylzinc for a zinc dopant. In other embodiments, n-type dopant precursors may include silane (SiH₄) or disilane (Si₂H₆) for a silicon dopant, hydrogen selenide (H₂Se) for a selenium dopant, and dialkyl tellurium compounds including dimethyltellurium, diethyltellurium, and diisopropyltellurium for a tellurium dopant.

The buffer layer 102 or layers may provide an intermediary between the growth wafer 101 and the semiconductor layers of the final photovoltaic unit that can accommodate their different crystallographic structures as the various epitaxial layers are formed. The one or more buffer layers 102 may be deposited to a thickness from about 100 nm to about 600 nm, such as a thickness of about 500 nm, for example. Each of the one or more buffer layers 102 may contain a Group III-V compound semiconductor, such as gallium arsenide, depending on the desired composition of the final photovoltaic unit. The buffer layer 102 may also be doped, such as an n-doped material, for example n-doped gallium arsenide.

A sacrificial layer 104 may be deposited on the buffer layer 102. The sacrificial layer 104 may contain a suitable material, such as aluminum arsenide or an aluminum arsenide alloy, and may be deposited to have a thickness within a range from about 3 nm to about 20 nm, such as from about 5 nm to about 10 nm, for example, about 10 nm. The sacrificial layer 104 may also be doped, such as an n-doped material, for example n-doped aluminum arsenide. The sacrificial layer 104, also known as the release layer, is etched and removed while separating the gallium arsenide based cell 140 from the growth wafer 101 during the ELO process. Prior to being etched, the sacrificial layer 104 is also utilized to form the lattice structure for the subsequently and epitaxially grown layers contained within the gallium arsenide based cell 140, such as the n-type contact layer 105.

The gallium arsenide based cell 140 includes an n-type film stack 120 containing n-doped gallium arsenide materials disposed over a p-type film stack 130 which contain p-doped gallium arsenide materials. Each of the n-type film stack 120 and the p-type film stack 130 independently contains multiple layers of varying compositions of materials including gallium arsenide materials. In one embodiment, the n-type film stack 120 includes an n-type contact layer 105, an n-type front window 106, an n-type absorber layer 108 formed adjacent the n-type front window 106, and optionally, an intermediate layer 114. The p-type film stack 130 includes a p-type emitter layer 110 and a p-type contact layer 112 formed on the p-type emitter layer 110.

During a fabrication process, as described in one embodiment, the n-type contact layer 105, or interface layer, may be deposited on the sacrificial layer 104. The n-type contact layer 105 contains Group III-V materials, such as gallium arsenide, depending on the desired composition of the final photovoltaic unit. The n-type contact layer 105 is n-doped, and for some embodiments, the doping concentration may be within a range greater than about 1×10¹⁸ atoms/cm³, such as greater than to 6×10¹⁸ atoms/cm³, for example, from greater than about 1×10¹⁸ atoms/cm³ to about 1×10¹⁹ atoms/cm³. The n-type contact layer 105 may be formed at a thickness within a range from about 10 nm to about 1,000 nm or from about 10 nm to about 100 nm, such as from about 25 nm to about 75 nm, for example, about 50 nm. The n-type contact layer 105 may be formed at this stage, such as a part of the gallium arsenide based cell 140 prior to the ELO process. Alternatively, in another embodiment, the n-type contact layer 105 may be formed at a later stage subsequent to the ELO process. One advantage to forming the n-type contact layer 105 as a part of the gallium arsenide based cell 140 prior to the ELO process is that the n-type contact layer 105 helps to protect the n-type front window 106 from undesired damage or material contamination during subsequent processing steps, such as while etching the sacrificial layer 104 during the ELO process.

An n-type front window 106, also known as a passivation layer, may be formed on the sacrificial layer 104, or if present, on the optional contact layer 105. The n-type front window 106 may contain a Group III-V material such as aluminum gallium, aluminum gallium arsenide, alloys thereof, or combinations thereof. The n-type front window 106 material may be n-doped, and for some embodiments, the doping concentration may be within a range greater than about 1×10¹⁸ atoms/cm³, such as greater than to 3×10¹⁸ atoms/cm³, for example, from greater than about 1×10¹⁸ atoms/cm³ to about 1×10¹⁹ atoms/cm³. The n-type front window 106 material may be non-doped. The aluminum gallium arsenide may have the formula of molar ratios, the AlₓGa₁₋ₓAs, for example, a molar ratio of Al₀.₃Ga_{0.7}As. The n-type front window 106 may be deposited to have a thickness within a range from about 5 nm to about 75 nm, for example, about 30 nm or about 40nm. The n-type front window 106 may be transparent to allow photons to pass through the n-type front window 106 on the front side of the gallium arsenide based cell 140 to other underlying layers.

Alternatively, the n-type front window 106 may contain a material such as aluminum gallium phosphide, aluminum gallium indium phosphide, alloys thereof, derivatives thereof, or combinations thereof. These aluminum gallium phosphide compounds provide for a large band gap, such as about 2.2 eV, as well as high collector efficiency at lower wavelengths when utilized within the n-type front window 106.

An absorber layer 108 may be formed on the front window 106. The absorber layer 108 may contain a Group III-V compound semiconductor, such as gallium arsenide. The absorber layer 108 may be monocrystalline. The absorber layer 108 may , for example, have only one type of doping, for example, n-doping, and for some embodiments, the doping concentration of the n-type absorber layer 108 may be within a range from about 1×10¹⁶ atoms/cm³ to about 1×10¹⁹ atoms/cm³, for example, about 1×10¹⁷ atoms/cm³. The thickness of the n-type absorber layer 108 may be within a range from about 300 nm to about 3,500 nm, such as from about 1,000 nm to about 2,000 nm (about 1.0 µm to about 2.0 µm), for example, 2,000 nm.

As illustrated in Figure 1B, an emitter layer 110, also referred to in some embodiments as a back window, may be formed adjacent the absorber layer 108. The emitter layer 110 may, for example, be p-doped. The p-type emitter layer 110 may contain a Group III-V compound semiconductor for forming a heterojunction with the n-type absorber layer 108. For example, if the n-type absorber layer 108 contains gallium arsenide, the p-type emitter layer 110 may contain a different semiconductor material, such as aluminum gallium arsenide. If the p-type emitter layer 110 and the n-type front window 106 both contain aluminum gallium arsenide, the AlₓGa₁₋ₓAs composition of the p-type emitter layer 110 may be the same as or different than the Al_{y}Ga_{1-y}As composition of the n-type front window 106. For example, the p-type emitter layer 110 may have a molar ratio of Al_{0.3}Ga_{0.7}As. The p-type emitter layer 110 may be monocrystalline. The p-type emitter layer 110 may be heavily p-doped and for some embodiments, the doping concentration of the p-doped emitter layer may be within a range from about 1×10¹⁷ atoms/cm³ to about 1×10²⁰ atoms/cm³, such as about 1×10¹⁹ atoms/cm³. The thickness of the p-type emitter layer 110 may be within a range from about 100 nm to about 500 nm, for example, about 300 nm. For some embodiments, the n-type absorber layer 108 may have a thickness of about 800 nm or less, such as about 500 nm or less, such as within a range from about 100 nm to about 500 nm.

In some embodiments, the contact of the n-type absorber layer 108 with the p-type emitter layer 110 creates a p-n interface layer for absorbing photons. In embodiments of the invention in which the n-type absorber layer 108 contains one material (such as gallium arsenide) and the p-type emitter layer 110 contains a different material having a different bandgap than the material of the absorber layer 108 (such as aluminum gallium arsenide), the p-n interface layer is a heterojunction. Heterojunctions, as described in embodiments herein, are observed to have reduced dark current, improved voltage productions, and improved radiative recombinations as compared to homojunctions of the conventional photovoltaic materials. When light is absorbed near the p-n interface layer to produce electron-hole pairs, the built-in electric field caused by the p-n junction may force the holes to the p-doped side and the electrons to the n-doped side. This displacement of free charges results in a voltage difference between the n-type absorber layer 108 and the p-type emitter layer 110 such that electron current may flow when a load is connected across terminals coupled to these layers. In some embodiments described herein, the material of the p-type emitter layer 110 has a higher bandgap than the material of the n-type absorber layer 108.

Rather than an n-type absorber layer 108 and a p-type emitter layer 110 as described above, conventional photovoltaic semiconductor devices typically have a p-doped base/absorber layer and an n-doped back/emitter layer. The base/absorber layer is typically p-doped in conventional devices due to the diffusion length of the carriers. Fabricating a thinner base/absorber layer according to embodiments of the invention allows for the change to an n-doped base/absorber layer. The higher mobility of electrons in an n-doped layer compared to the mobility of holes in a p-doped layer leads to the lower doping density in the n-type absorber layer 108 as described by embodiments herein. Other embodiments may use a p-doped base/absorber layer and an n-doped back/emitter layer.

Alternatively, as shown in Figure 1B, an intermediate layer 114 may be formed between the n-type absorber layer 108 and the p-type emitter layer 110. The intermediate layer 114 can provide a material transition between the n-type absorber layer 108 and the p-type emitter layer 110. The intermediate layer may contain aluminum gallium arsenide may have the formula of molar ratios, the AlₓGa₁₋ₓAs, for example, a molar ratio of Al_{0.3}Ga_{0.7}As and be n-doped within a range from about 1×10¹⁶ atoms/cm³ to about 1×10¹⁹ atoms/cm³ for example 1×10¹⁷ atoms/cm³, and the dopant concentrations are preferably the same or substantially the same as the n-type absorber layer 108. In one embodiment of the intermediate layer 114, the intermediate layer 114 contains a graded layer 115 and an n-type back window 117 disposed between the n-type absorber layer 108 and the p-type emitter layer 110. The graded layer 115 is formed over the n-type absorber layer 108 and the n-type back window 117 is formed over the graded layer 115, prior to forming the p-type emitter layer 110 over n-type back window 117.

The graded layer 115 may be a graded layer from gallium arsenide adjacent the n-type absorber layer 108 to aluminum gallium arsenide adjacent the n-type back window 117. In many examples, the aluminum gallium arsenide may have the formula of molar ratios, the AlₓGa₁₋ₓAs, for example, a molar ratio of Al_{0.3}Ga_{0.7}As. The gradation of the graded layer 115 may be parabolic, exponential or linear in gradation. In another embodiment, the intermediate layer 114 contains only the graded layer 115 or the n-type back window 117. The n-type back window 117 may also contain aluminum gallium arsenide and may have the formula of molar ratios, the AlₓGa₁₋ₓAs, for example, a molar ratio of Al_{0.3}Ga_{0.7}As. Each of the graded layer 115 and the n-type back window 117 may be n-doped, and for some embodiments, the doping concentration may be within a range from about 1×10¹⁶ atoms/cm³ to about 1×10¹⁹ atoms/cm³, for example 1×10¹⁷ atoms/cm³, and the dopant concentrations are preferably the same or substantially the same as the n-type absorber layer 108.

Optionally, a p-type contact layer 112 may be formed on the p-type emitter layer 110. The p-type contact layer 112 may contain a Group III-V compound semiconductor, such as gallium arsenide. The p-type contact layer 112 is generally monocrystalline and p-doped, and for some embodiments, the doping concentration of the p-type contact layer 112 may be greater than 1×10¹⁸ atoms/cm³, such as from about 6×10¹⁸ atoms/cm³ to about 2×10¹⁹ atoms/cm³, for example, about 1×10¹⁹ atoms/cm³. The p-type emitter layer 110 may have a thickness within a range from about 10 nm to about 100 nm, for example, about 50 nm.

Once the p-type emitter layer 110 has been formed, cavities or recesses (not shown) may be formed in the p-type emitter layer 110 (or optional p-type contact layer 112) deep enough to reach the underlying base n-type absorber layer 108. Such recesses may be formed by applying a mask to the p-type emitter layer 110 (or optional p-type contact layer 112) using photolithography, for example, and removing the material in the p-type emitter layer 110 (and optional p-type contact layer 112) not covered by the mask using a technique, such as wet or dry etching. In this manner, the n-type absorber layer 108 may be accessed via the back side of the gallium arsenide based cell 140.

In other embodiments, the opposite type of doping can be used in the layers discussed above, and/or other materials can be used that can provide the described heterojunction and p-n junction. Furthermore, in other embodiments the layers can be deposited or formed in a different order than the order described above.

A photovoltaic unit created in this manner has a significantly thin absorber layer, for example, less than 500 nm) compared to conventional solar units, which may be several micrometers thick. The thickness of the absorber layer is proportional to dark current levels in the photovoltaic unit (e.g., the thinner the absorber layer, the lower the dark current). Dark current is the small electric current that flows through the photovoltaic unit or other similar photosensitive device, for example, a photodiode, even when no photons are entering the device. This background current may be present as the result of thermionic emission or other effects. Because the open circuit voltage (*V_{oc}*) increases as the dark current is decreased in a photosensitive semiconductor device, a thinner absorber layer may most likely lead to a greater *V_{oc}* for a given light intensity and, thus, increased efficiency. As long as the absorber layer is able to trap light, the efficiency increases as the thickness of the absorber layer is decreased.

The thinness of the absorber layer may not only be limited by the capabilities of thin film technology and ELO. For example, efficiency increases with the thinness of the absorber layer, but the absorber layer should be thick enough to carry current. However, higher doping levels may allow current to flow, even in very thin absorber layers. Therefore, increased doping may be utilized to fabricate very thin absorber layers with even greater efficiency. Conventional photovoltaic devices may suffer from volume recombination effects, and therefore, such conventional devices do not employ high doping in the absorber layer. The sheet resistance of the absorber layer may also be taken into consideration when determining the appropriate thickness.

Photovoltaic devices which contain a thin absorber layer as described herein are usually more flexible than conventional solar cells having a thickness of several micrometers. Also, the thin absorber layers as described herein provide increased efficiency over conventional solar cells. Therefore, photovoltaic units according to embodiments of the invention may be appropriate for a greater number of applications than conventional solar cells.

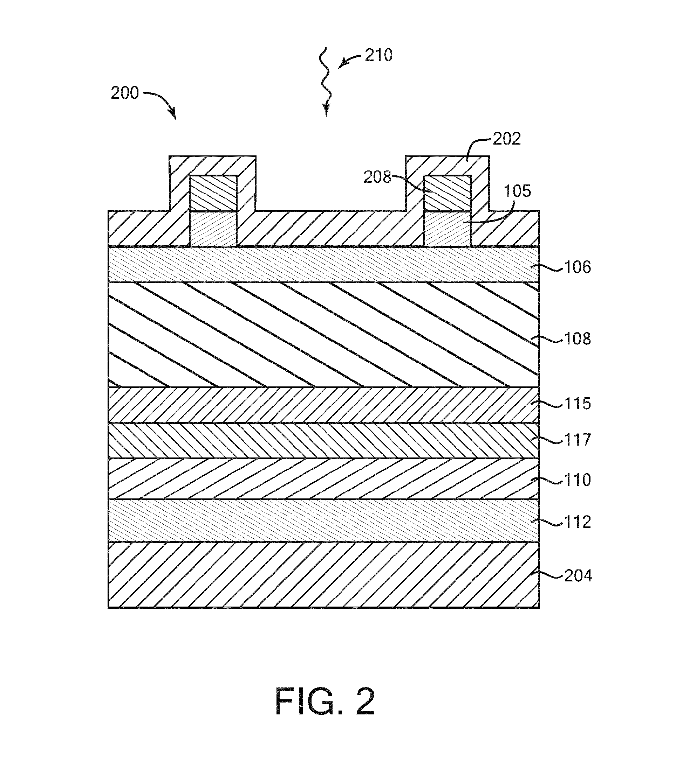

Figure 2 depicts one embodiment of a photovoltaic cell 200 which is a two-sided photovoltaic device and therefore contains each of the contacts, such as the p-metal contact layer 204 and the n-metal contact layer 208, disposed on opposite sides of photovoltaic cell 200. The n-metal contact layer 208 is disposed on the front side or sun side to receive light 210 while the p-metal contact layer 204 is disposed on the back side of photovoltaic cell 200. The photovoltaic cell 200 may be formed from the gallium arsenide based cell 140, as depicted in Figure 1B, and as described by embodiments herein.

In one embodiment, an n-metal contact layer 208 is deposited on the n-type contact layer 105 and subsequently, recesses are formed through the n-metal contact layer 208 and the n-type contact layer 105 to expose the n-type front window 106 on the front side of the photovoltaic cell 200. In an alternative embodiment, recesses may be initially formed in the n-type contact layer 105 to expose the n-type front window 106 on the front side of the photovoltaic cell 200. Thereafter, the n-metal contact layer 208 may be formed on the remaining portions of the n-type contact layer 105 while leaving exposed the n-type front window 106. The n-type contact layer 105 contains n-doped gallium arsenide materials which may have a dopant concentration of greater than about 3×10¹⁸ atoms/cm³, such as within a range from greater than about 6×10¹⁸ atoms/cm³ to about 1×10¹⁹ atoms/cm³.

An anti-reflective coating (ARC) layer 202 may be disposed over the exposed n-type front window 106, as well as the n-type contact layer 105 and the n-metal contact layer 208, in accordance with an embodiment of the invention. The ARC layer 202 contains a material that allows light to pass through while preventing light reflection from the surface of the ARC layer 202. For example, the ARC layer 202 may contain magnesium fluoride, zinc sulfide, titanium oxide, silicon oxide, derivatives thereof, or combination thereof. The ARC layer 202 may be applied to the n-type front window 106 by a technique, such as sputtering. The ARC layer 202 may have a thickness within a range from about 25 nm to about 200 nm, such as from about 50 nm to about 150 nm.

For some embodiments, the n-type front window 106, the p-type emitter layer 110, and/or the p-type contact layer 112 may be roughened or textured before applying the ARC layer 202. Each of the n-type front window 106, the p-type emitter layer 110, and/or the p-type contact layer 112 may be roughened by an etching process, such as a wet etching process or a dry etching process. Texturing may be achieved by applying small particles, such as polystyrene spheres, to the surface of the n-type front window 106 before applying the ARC layer 202. By roughening or texturing the n-type front window 106, the p-type emitter layer 110, and/or the p-type contact layer 112, different angles are provided at the interface between the ARC layer 202 and the n-type front window 106, which may have different indices of refraction. In this manner, more of the incident photons may be transmitted into the n-type front window 106 rather than reflected from the interface between the ARC layer 202 and the n-type front window 106 because some angles of incidence for photons are too high according to Snell's Law. Thus, roughening or texturing the n-type front window 106, the p-type emitter layer 110, and/or the p-type contact layer 112 may provide increased trapping of light.

In some embodiments, the n-type front window 106 may contain multiple window layers. For these embodiments, the outermost window layer (e.g., the window layer closest to the front side of the photovoltaic cell 200) may be roughened or textured as described above before the ARC layer 202 is applied, as illustrated in Figure 2. In one embodiment, the n-type front window 106 contains a first window layer (not shown) disposed adjacent to the n-type absorber layer 108 and a second window layer (not shown) interposed between the first window layer and the ARC layer 202. The first and second window layers may contain any material suitable for the n-type front window 106 as described above, such as aluminum gallium arsenide, but typically with different compositions. For example, the first window layer may contain Al_{0.3}Ga_{0.7}As, and the second window layer may contain Al_{0.1}Ga_{0.9}As. Furthermore, some of the multiple window layers may be doped, while others are undoped for some embodiments. For example, the first window layer may be doped, and the second window layer may be undoped.

The p-metal contact layer 204 and/or the n-metal contact layer 208 each contain contact materials which are electrically conductive materials, such as metals or metal alloys. Preferably, the contact materials contained within the p-metal contact layer 204 and/or the n-metal contact layer 208 do not diffuse through other layers, such as a semiconductor layer, during any of the process steps utilized during the fabrication of the photovoltaic cell 200. Usually, each of the p-metal contact layer 204 and the n-metal contact layer 208 contains multiple layers of the same or different contact materials. The contact materials preferably have specific contact resistance of 1×10⁻³ Ω-cm² or less. Preferred contact materials also have Schottky barrier heights (Φ_{bn}) of about 0.8 eV or greater at carrier concentrations of about 1×10¹⁸ atoms/cm³. Suitable contact materials may include gold, copper, silver, aluminum, palladium, platinum, titanium, zirconium, nickel, chromium, tungsten, tantalum, ruthenium, zinc, germanium, palladium germanium alloy, derivatives thereof, alloys thereof, or combinations thereof.

In some embodiments described herein, the p-metal contact layer 204 and/or the n-metal contact layer 208 may be fabricated on the photovoltaic cell 200 by a method, such as vacuum-evaporation through a photoresist, photolithography, screen printing, or merely depositing on the exposed surface of the photovoltaic cell 200 that have been partially covered with a resist mask, a wax, or another protective material. Many of these deposition processes include covering or protecting a portion of the surface of photovoltaic cell 200 while depositing, plating, printing, or otherwise forming a contact material onto a design pattern contained on the uncovered, unprotected, or otherwise exposed surface of the surface of photovoltaic cell 200. In several examples, screen printing may be the most cost effective way to form the contact materials.

In some embodiments, the p-metal contact layer 204 contains a first conductive layer having a thickness within a range from about 500 Å to about 2,000 Å, such as about 1,000 Å, a second conductive layer having a thickness within a range from about 10,000 Å to about 25,000 Å, such from about 15,000 Å to about 20,000 Å and disposed on the first conductive layer, and a third conductive layer having a thickness within a range from about 500 Å to about 2,000 Å, such as about 1,000 Å and disposed on the second conductive layer. In one example, the p-metal contact layer 204 contains the first conductive layer containing silver or nickel and having a thickness of about 1,000 Å, the second conductive layer containing copper and having a thickness of about 18,000 Å, and the third conductive layer containing gold and having a thickness of about 1,000 Å.

In some embodiments, the n-metal contact layer 208 contains a first conductive layer having a thickness within a range from about 500 Å to about 2,000 Å, such as about 1,000 Å, a second conductive layer having a thickness within a range from about 10,000 Å to about 25,000 Å, such from about 15,000 Å to about 20,000 Å and disposed on the first conductive layer, and a third conductive layer having a thickness within a range from about 500 Å to about 2,000 Å, such as about 1,000 Å and disposed on the second conductive layer. In one example, the n-metal contact layer 208 contains the first conductive layer containing gold and having a thickness of about 1,000 Å, the second conductive layer containing silver and having a thickness within a range from about 15,000 Å to about 20,000 Å, and the third conductive layer containing gold, copper, or aluminum and having a thickness of about 1,000 Å.

In another embodiment, the p-metal contact layer 204 may contain a reflector layer formed as one or multiple layers contained within the p-metal contact layer 204. The p-metal contact layer 204 may be a material selected from the group of silver, aluminum, gold, platinum, copper, nickel, alloys thereof, or combinations thereof. In one example, the p-metal contact layer 204 contains silver or a silver alloy. In another example, the p-metal contact layer 204 is a silver-containing contact layer. The reflector layer may have a thickness within a range from about 0.01 µm to about 1 µm, preferably, from about 0.05 µm to about 0.5 µm, and more preferably, from about 0.1 µm to about 0.3 µm, for example, about 0.2 µm or about 0.1 µm (1,000 Å). The reflector layer may be deposited by a vapor deposition process, such as physical vapor deposition (PVD), sputtering, electron beam deposition (e-beam), ALD, CVD, PE-ALD, or PE-CVD, or by other deposition processes including inkjet printing, screen printing, evaporation, electroplating, electroless deposition (e-less), or combinations thereof.

Optionally, a metal protective layer, or metal adhesion layer, may be deposited on the p-metal contact layer 204. The metal protective layer may contain a material including nickel, chromium, titanium, alloys thereof, or combinations thereof. The metal protective layer preferably exhibits good adhesion to p-doped gallium arsenide. In one example embodiment, the metal protective layer may be deposited to a thickness within a range from about 5 Å to about 20 Å and have a reflectance of about 80% or greater. Preferably, the material of the metal protective layer and deposition thickness are deposited to minimize any interference with the reflectiveness of the p-metal contact layer 204. For example, a film containing nickel and having a thickness of about 20 Å was observed to have a reflectance of about 80% and a film containing nickel and having a thickness of about 10 Å was observed to have a reflectance of about 90% for a wavelength within a range from about 870 nm to about 1,000 nm. In one example, a film containing nickel and having a thickness of about 10 Å thick was used as a metal protective layer for a metal the p-metal contact layer 204. The metal the p-metal contact layer 204 may contain gold, copper, silver, nickel, aluminum, alloys thereof, or combinations thereof. The metal protective layer may be deposited by an electron beam deposition process or a PVD process, also known as a sputtering process.

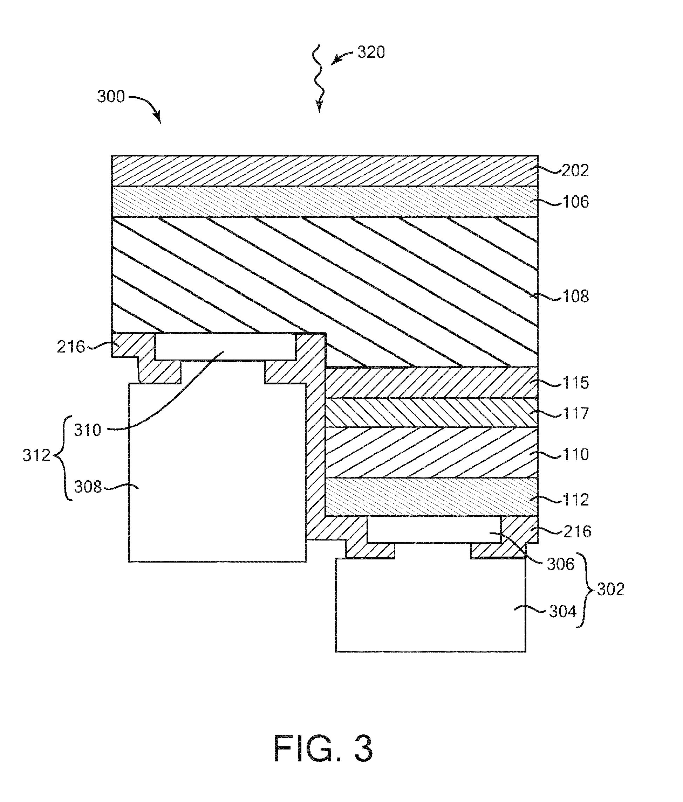

Figure 3 depicts a photovoltaic cell 300 which is a single-sided photovoltaic device and therefore contains both contacts, such as the p-metal contact 302 and the n-metal contact 312, disposed on the same side of photovoltaic cell 300, as described by other embodiments herein. As shown in Figure 3, both the p-metal contact 302 and the n-metal contact 312 are on the back side of the photovoltaic cell 300 while the ARC layer 202 is on the sun side or front side of the photovoltaic cell 300 that receives light 320. The p-metal contact 302 contains a p-metal contact layer 304 disposed on a p-metal contact layer 306, while the n-metal contact 312 contains an n-metal contact layer 308 disposed on an n-metal alloy contact 310, in some embodiments described herein.

In some embodiments, the photovoltaic cell 300 may be formed from the gallium arsenide based cell 140 of Figure 1B. In one example, a resist mask may be formed on the exposed surface of the p-type contact layer 112 and pattern recesses and holes may be formed during a photolithography process. The pattern recesses and holes extend through the p-type contact layer 112, the p-type emitter layer 110, the n-type back window 117, and the graded layer 115, and partially into the n-type absorber layer 108. Thereafter, the resist mask is removed to reveal the n-type absorber layer 108 and the p-type contact layer 112 as the exposed surfaces on the back side of the photovoltaic cell 300, as viewed from the two-dimensional perspective towards the back side of the photovoltaic cell 300. The sidewalls of the recesses and holes reveal exposed surfaces of the p-type contact layer 112, the p-type emitter layer 110, the n-type back window 117, and the graded layer 115, and partially into the n-type absorber layer 108.

In one embodiment, the p-metal contact layer 306 is formed on a portion of the exposed the p-type contact layer 112 and the n-metal alloy contact 310 is formed on a portion of the exposed the n-type absorber layer 108. Thereafter, the insulation layer 216 may be deposited over the surface of the photovoltaic cell 300, such as to cover all exposed surfaces including the p-metal contact layer 306 and the n-metal alloy contact 310. Subsequently, the exposed surfaces of the p-metal contact layer 306 and the n-metal alloy contact 310 are revealed by etching pattern holes into the insulation layer 216 by a lithography process. In some embodiments, the p-metal contact layer 306 and the n-metal alloy contact 310 are formed prior to separating the gallium arsenide based cell 140 from the growth wafer 101 during the ELO process while the insulation layer 216 is formed subsequent to the ELO process. The p-metal contact layer 304 may be formed on the p-metal contact layer 306 and a portion of the insulation layer 216 while the n-metal contact layer 308 may be formed on the n-metal alloy contact 310 and other portions of the insulation layer 216 to form the photovoltaic cell 300, as depicted in Figure 3. In some examples, the p-metal contact layer 304 and the n-metal contact layer 308 may be formed containing the same compositional layers of material as each other and in other examples, the p-metal contact layer 304 and the n-metal contact layer 308 are simultaneously formed on the photovoltaic cell 300 during the same metallization steps.

In an alternative embodiment, the p-metal contact 302 and the n-metal contact 312 may be fabricated, in whole or in part, and subsequently, the insulation layer 216 may be formed over and on the sidewalls of the recesses between and around the p-metal contact 302 and the n-metal contact 312. In another alternative embodiment, the insulation layer 216, in whole or in part, may be formed on the photovoltaic cell 300 prior to forming the p-metal contact 302 and the n-metal contact 312.

Despite all the contacts, such as the p-metal contact 302 and the n-metal contact 312, being on the back side of the photovoltaic cell 300 to reduce solar shadows, dark current and its stability with time and temperature may still be concerns when designing an efficient photovoltaic device, such as the photovoltaic cell 300. Therefore, for some embodiments, an insulation layer 216 may be deposited or otherwise formed on the back side of the photovoltaic cell 300. The insulation layer 216 contains an electrically insulating material or grout which helps to reduce the dark current within the photovoltaic cell 300.

The insulation layer 216 may contain an electrically insulating material or grout, such as silicon oxides, silicon dioxide, silicon oxynitride, silicon nitride, polysiloxane or silicone, sol-gel materials, titanium oxide, tantalum oxide, zinc sulfide, derivatives thereof, or combinations thereof. The insulation layer 216 may be formed by a passivation method, such as by a sputtering process, an evaporation process, a spincoating process, or a CVD process.

In another embodiment, the insulation layer 216 eliminates or substantially reduces electrical shorts from occurring between the p-metal contact 302 and the n-metal contact 312. The insulation layer 216 contains an electrically insulating grout and/or other electrically insulating material that has an electrical resistance of at least 0.5 MΩ (million ohms) or greater, such as within a range from about 1 MΩ to about 5 MΩ, or greater. Exemplary grouts or other electrically insulating materials may contain a polymeric material, such as ethylene vinyl acetate (EVA), polyimide, polyurethane, derivatives thereof, or combinations thereof. In one example, the electrically insulating grout contains a photosensitive polyimide coating. In another example, the electrically insulating grout contains a thermal set polymeric material.

In many embodiments, the n-metal alloy contact 310 may be formed by a low temperature process, which includes low temperature deposition processes followed by a low temperature, thermal anneal process. In some embodiments, the low temperature thermal anneal process is performed at temperatures within a range from about 20°Cto about 275°C. For example, in one embodiment, the low temperature thermal anneal process is performed at temperatures as low as room temperature, such as within a range from about 20°Cto about 175°C,while in another embodiment, the low temperature thermal anneal process is performed at temperatures as low as 150°C, such as within a range from about 150°Cto about 275°C. Typically for forming contacts to gallium arsenide materials, the contact forming processing temperatures require 300°Cto 400°Cor higher, as well as the need of complex metallurgy of the contact materials.

Suitable contact materials deposited within the n-metal alloy contact 310 by low temperature deposition processes may include palladium, germanium, palladium germanium alloy, titanium, gold, nickel, silver, copper, platinum, alloys thereof, or combinations thereof, among others. It is believed that one of the benefits of the low temperature deposition process is the elimination of conventional higher temperature depositions (e.g., 300°C,400°C,or higher) and annealing steps following the contact material deposition step in conventional processing, which is believed to allow for retention of higher concentration dopants in adjacent materials, for example, the n-type front window 106, the p-type emitter layer 110, and/or the n-type back window 117, as compared to conventional processing techniques.

In another embodiment, the n-metal alloy contact 310 may contain multiple layers of conductive materials including a palladium germanium alloy. The n-metal alloy contact 310 is disposed between the n-type absorber layer 108 and the n-metal contact layer 308 for providing a strong ohmic contact therebetween. The palladium germanium alloy within the n-metal alloy contact 310 allows a high conductivity of the electric potential from the gallium arsenide materials within the n-type absorber layer 108, across n-metal alloy contact 310, and to the n-metal contact layer 308.

The n-metal alloy contact 310 also contains a metallic capping layer which can be provided, for example, on the palladium germanium alloy layer. In some embodiments, the capping layer can include an adhesion layer and a high conductivity layer. For example, the adhesion layer can allow the conductivity layer to adhere to the alloy layer. In some examples, the adhesion layer may contain titanium, tin, zinc, alloys thereof, or combinations thereof and the high conductivity layer may contain gold, silver, nickel, copper, aluminum, alloys thereof, or combinations thereof, or a stack of multiple different metal layers and/or alloy layers. In one example, the n-metal alloy contact 310 contains a high conductivity layer containing gold disposed on an adhesion layer containing titanium, which is disposed on a palladium germanium alloy.

In some embodiments, a palladium germanium alloy may be formed within the n-metal alloy contact 310 by depositing a palladium containing layer on the underlying layer, such as the n-type absorber layer 108, depositing a germanium containing layer on the palladium containing layer, and then depositing the capping layer on the germanium containing layer. The depositing of the capping layer can include, for example, depositing the adhesion layer on the germanium layer and depositing the high conductivity layer on the adhesion layer. Each of the palladium containing layer, the germanium containing layer, the adhesion layer, and the high conductivity layer may independently be deposited or otherwise formed by a PVD process, a room temperature evaporation method, an electroplating process, or an electroless deposition process. For example, the palladium layer can be deposited at a temperature within a range from about 20°Cto about 200°Cduring a deposition process. In another example, the germanium layer can be deposited at a temperature within a range from about 20°Cto about 200°C during a deposition process.

The palladium germanium alloy may be formed on a variety of materials contained by the underlying layer however, strong ohmic contact is formed between the palladium germanium alloy and gallium arsenide materials, such as n-type gallium arsenide materials found in photovoltaic absorber layers. Therefore, the palladium germanium alloy is utilized by embodiments described herein as an ohmic contact with the n-type absorber layer 108.

The palladium containing layer may have a thickness within a range from about 50 Å to about 500 Å, such as from about 50 Å to about 300 Å, such as about 150 Å. The germanium containing layer may have a thickness within a range from about 50 Å to about 1,000 Å, such as from about 100 Å to about 1000 Å, such as about 300 Å. The adhesion layer may have a thickness of at least about 10 Å or 20 Å, such as a thickness within a range from about 10 Å to about 100 Å, or from about 20 Å to about 80 Å, e.g. about 50 Å. The high conductivity layer may have a thickness of at least about 500 Å or 1000 Å, such as a thickness within a range from about 500 Å to about 5,000 Å, or from about 1,000 Å to about 2,000 Å, e.g., about 1,500 Å.

In one example, the n-metal alloy contact 310 may be formed having the palladium containing layer comprising metallic palladium or a palladium alloy and having a thickness of about 150 Å, the germanium containing layer comprising metallic germanium or a germanium alloy and having a thickness of about 300 Å, the adhesion layer comprising metallic titanium or a titanium alloy and having a thickness of about 50 Å, and the high conductivity layer comprising metallic gold or a gold alloy and having a thickness of about 1,500 Å.

Subsequently, the method for forming the palladium germanium alloy within the n-metal alloy contact 310 includes annealing the photovoltaic cell 300 to a low temperature, thermal anneal process. In one embodiment, the low temperature, thermal anneal process is performed at a temperature within a range from about 20°C to about 275°C,such as from about 20°Cto about 175°C,for example, from about 100°Cto about 150°C or from about 150°C to about 275°C. The anneal process can in some embodiments be for a time period within a range from about 5 minutes to about 60 minutes, for example, about 30 minutes, or for at least 30 seconds. In many examples, the low temperature, thermal anneal process is performed at a temperature within a range from about 100°Cto about 150°Cfor a time period within a range from about 5 minutes to about 60 minutes. In one example, the low temperature, thermal anneal process is performed at a temperature of about 125°Cfor a time period of about 30 minutes. In other examples, the low temperature, thermal anneal process is performed at a temperature within a range from about 20°C to about 175°Cfor a time period within a range from about 5 minutes to about 60 minutes.

In another embodiment, the low temperature, thermal anneal process is performed at a temperature within a range from about 150°Cto about 275°C,such as from about 200°Cto about 275°Cor from about 240°Cto about 260°C and for a time period for at least about 0.5 minutes, for example, about 1 minute. In another example, the low temperature, thermal anneal process is performed at a temperature of about 250°Cfor a time period of about 1 minute.

In some embodiments described herein, the palladium germanium alloy formed within the n-metal alloy contact 310 may have a uniformed composition of palladium germanium material such that the palladium and germanium atoms are substantially distributed throughout the palladium germanium alloy within the n-metal alloy contact 310. In other embodiments described herein, the palladium germanium alloy formed within the n-metal alloy contact 310 may have a non-uniformed or graded composition of palladium germanium material. The non-uniformed or graded composition of palladium germanium material contains the highest concentration of palladium and the lowest concentration of germanium nearest the n-type absorber layer 108 with a gradient extending to the opposite of the n-metal alloy contact 310, which contains the highest concentration of germanium and the lowest concentration of palladium. The palladium germanium alloy contained within the n-metal alloy contact 310 may have a thickness within a range from about 100 Å to about 1,000 Å, such as from about 300 Å to about 600 Å, for example, about 450 Å.

While the n-metal alloy contact 310 is described herein with regarding to the structure described herein, the low temperature contact formation process may be used in the formation of additional photovoltaic devices, of which examples of additional structures may be found in U.S. Ser. No. 12/605,108, filed on October 23, 2009, and is incorporated herein by reference to the extent not inconsistent with the description and recited claims detailed herein. Additionally, while the p-metal contact layer 304 and the n-metal alloy contact 310 are described as back side contacts, the deposition processes for the p-metal contact layer 304 and the n-metal alloy contact 310 may be used for forming both front side and back side contact in various photovoltaic structures.

The p-metal contact 302 containing the p-metal contact layer 304 and the p-metal contact layer 306, as well as the n-metal contact 312 containing the n-metal contact layer 308 and the n-metal alloy contact 310, contain contact materials which are electrically conductive materials, such as metals or metal alloys. Preferably, the contact materials contained within the p-metal contact 302 and/or the n-metal contact 312 do not diffuse through other layers, such as a semiconductor layer, during any of the process steps utilized during the fabrication of the photovoltaic cell 300. Usually, each of the p-metal contact layer 306 and the n-metal contact layer 308 contains multiple layers of the same or different contact materials. The contact materials preferably have specific contact resistance of 1×10⁻³ Ω-cm² or less. Preferred contact material also have Schottky barrier heights (Φ_{bn}) of about 0.8 eV or greater at carrier concentrations of about 1×10¹⁸ atoms/cm³. Suitable contact materials which may be contained within the p-metal contact 302 and/or the n-metal contact 312 include gold, copper, silver, aluminum, palladium, platinum, titanium, zirconium, nickel, chromium, tungsten, tantalum, ruthenium, zinc, germanium, palladium germanium alloy, derivatives thereof, alloys thereof, or combinations thereof.

In some embodiments described herein, the p-metal contact layer 306 may be fabricated on the photovoltaic cell 300. For example, similar fabrication methods and embodiments as described above for the p-metal contact layer 204 and/or the n-metal contact layer 208 on cell 200 can be used for the p-metal contact layer 306 on photovoltaic cell 300.

In some embodiments, the p-metal contact layer can contain a first conductive layer, second conductive layer, and third conductive layer that are similar to and/or similarly formed as corresponding layers described above for the p-metal contact layer 204. Furthermore, in some embodiments, the p-metal contact layer 306 may contain a reflector layer formed as one or multiple layers contained within the p-metal contact layer 306, which can be similar to the reflector layer and/or methods for forming such reflector layer as described above for p-metal contact layer 204, for example. In addition, in some embodiments, a metal protective layer, or metal adhesion layer, may optionally be deposited on the p-metal contact layer 306, which can be similar to and/or similarly formed as the metal protective layer described above for the p-metal contact layer 204.

Additionally, in some embodiments, the p-metal contact layer 304 and the n-metal contact layer 308 each independently contains a first conductive layer, a second conductive layer, and a third conductive layer that can be, for example, similar to and/or similarly formed as corresponding layers of n-metal contact layer 208 described above.

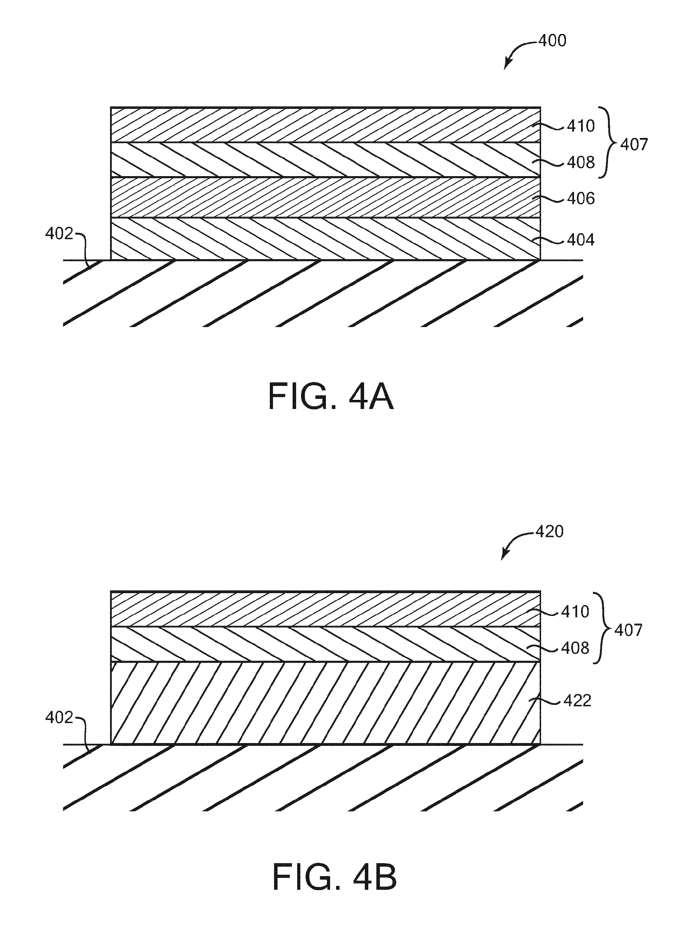

Figure 4A depicts one embodiment of a first structure 400 in the formation of a metallic contact on a photovoltaic device 402. One example of the metallic contact is the n-metal alloy contact 310 described above with reference to Fig. 3. Structure 400 includes four layers which have been deposited on a device 402.

A palladium containing layer 404 can be deposited on the device 402, e.g., deposited on an underlying layer such as the absorber layer 108 of a device 300 as described above with reference to Fig. 3 in some embodiments. A germanium containing layer 406 can be deposited on the palladium containing layer 404. A metallic capping layer 407 can be deposited on the germanium layer 404. In the embodiment shown, the metallic capping layer 407 includes an adhesion layer 408 deposited on the germanium containing layer 406, and a high conductivity layer 410 deposited on the adhesion layer 408. In some embodiments, these layers can be deposited using techniques described above, and with thicknesses and materials as described above, with reference to contact 310.

Figure 4B depicts one embodiment of a resulting structure 420 which has been formed from the first structure 400 of Fig. 4A. In some embodiments, the structure 420 is formed by annealing the cell including the structure 400 to a low temperature, thermal anneal process, similarly as described above with reference to n-metal alloy contact 310.

Structure 420 includes a palladium germanium alloy layer 422 and a metallic capping layer 407. The alloy layer 422 includes a palladium germanium alloy resulting from the annealing process applied to the cell including palladium containing layer 404 and germanium containing layer 406 of Fig. 4A. For example, the characteristics of the palladium germanium alloy layer 422 can be as described above with reference to n-metal contact 310. The capping layer 407 is located over the palladium germanium alloy layer 422, and can include the adhesion layer 408 and high conductivity layer 410 as described above. A metal contact layer, such as n-metal contact layer 308 described for Fig. 3, can be deposited on the capping layer 407 to provide a contact layer for the metal contact.

While the foregoing is directed to embodiments of the invention, other and further embodiments of the inventions may be devised without departing from the basic scope thereof, and the scope thereof is determined by the claims that follow.

## Claims

1. A method for forming a metallic contact on a photovoltaic device, comprising:
depositing a palladium layer on an absorber layer of a photovoltaic cell;
depositing a germanium layer on the palladium layer;
depositing a metallic capping layer on the germanium layer; and
heating the photovoltaic cell to a temperature within a range from about 20°Cto about 275°Cto form a palladium germanium alloy disposed between the absorber layer and the metallic capping layer.

2. The method of claim 1, wherein depositing the metallic capping layer includes:
depositing an adhesion layer on the germanium layer; and
depositing a conductive layer on the adhesion layer.

3. The method of claim 1, wherein the heating is performed for a time period within a range of about 5 minutes to about 60 minutes.

4. The method of claim 1, wherein the temperature is within a range from about 150°Cto about 275°C and the heating is performed for a time period of at least about 30 seconds.

5. The method of claim 3, wherein the temperature is within a range from about 100°Cto about 150°C, and the heating is performed for a time period within a range from about 5 minutes to about 60 minutes.

6. The method of claim 1, wherein the temperature is within a range from about 20°Cto about 175°Cand the heating is for a time period within a range from about 5 minutes to about 60 minutes.

7. The method of claim 1, wherein the palladium layer has a thickness within a range from about 50 Å to about 300 Å and is deposited at a temperature within a range from about 20°Cto about 200°C during a deposition process.

8. The method of claim 1, wherein the germanium layer has a thickness within a range from about 100 Å to about 1000 Å and is deposited at a temperature within a range from about 20°Cto about 200°Cduring a deposition process.

9. The method of claim 2, wherein the adhesion layer comprises titanium or a titanium alloy and has a thickness of at least about 20 Å.

10. The method of claim 2, wherein the conductive layer comprises gold or a gold alloy and has a thickness of at least about 1,000 Å.

11. The method of claim 1, wherein the absorber layer of the photovoltaic cell comprises an n-type gallium arsenide material.

12. The method of claim 11, wherein the metallic contact is disposed on the back side of the photovoltaic cell.

13. A method for forming a metallic contact on a photovoltaic device, comprising:
depositing a palladium layer on an absorber layer of a photovoltaic cell;
depositing a germanium layer on the palladium layer;
depositing an adhesion layer on the germanium layer;
depositing a conductive layer on the adhesion layer; and
heating the photovoltaic cell to a temperature within a range from about 150°Cto about 275°Cfor a time period of at least 0.5 minutes to form a palladium germanium alloy disposed between the absorber layer and the adhesion layer.

14. A metallic contact disposed on a photovoltaic device, comprising:
a palladium germanium alloy layer disposed on an absorber layer of a photovoltaic cell; and
a metallic capping layer disposed on the palladium germanium alloy layer.

15. The metallic contact of claim 14, wherein the metallic capping layer includes:
an adhesion layer disposed on the palladium germanium alloy layer; and
a conductive layer disposed on the adhesion layer.

16. The metallic contact of claim 15, wherein the adhesion layer contains titanium.

17. The metallic contact of claim 15, wherein the conductive layer contains gold.

18. The metallic contact of claim 14, wherein the palladium germanium alloy layer has a thickness within a range from about 100 Å to about 1,000 Å.

19. The metallic contact of claim 18, wherein the thickness of the palladium germanium alloy layer is within a range from about 300 Å to about 600 Å.

20. The metallic contact of claim 15, wherein the adhesion layer has a thickness of at least about 20 Å.

21. The metallic contact of claim 15, wherein the conductive layer has a thickness of at least about 1,000 Å.

22. The metallic contact of claim 14, wherein the absorber layer of the photovoltaic cell comprises an n-type gallium arsenide material.

23. The metallic contact of claim 14, wherein the metallic contact is disposed on the back side of the photovoltaic cell.
